# EUROPEAN PATENT APPLICATION

(11) **EP 4 760 231 A1**
(43) Date of publication of application: **17.06.2026**
(21) Application number: 25738836.3
(22) Date of filing: 08.01.2025
(51) Int. Cl.: G01N 3/08, G01R 31/385, G01R 31/367, G01R 31/396, G06N 20/00, H01M 10/42, B23K 31/12

(54) **BATTERY DIAGNOSIS DEVICE, BATTERY DIAGNOSIS METHOD, AND BATTERY DIAGNOSIS SYSTEM**

(30) Priority: 08.01.2024 KR 20240003046
(71) Applicant: LG Energy Solution, Ltd., Seoul 07335 (KR)
(72) Inventor: BAE, Min Gu, Daejeon 34122 (KR); LIM, Sung Sang, Daejeon 34122 (KR); KIM, Sung Ryul, Daejeon 34122 (KR)
(74) Representative: BCKIP Part mbB
(86) International application number: PCT/KR2025/000378
(87) International publication number: WO 2025/150869

(57) **Abstract**

According to some embodiments, a battery diagnosis device includes a data management unit configured to collect an electric signal dataset of a welding process of forming an electrode tab on a plurality of sample battery cells and collect a fracture energy dataset of a fracture experiment for measuring a tensile strength while separating the electrode tab from the plurality of sample battery cells and a control unit configured to generate a fracture energy estimation model for estimating fracture energy values corresponding to electric signal values based on the electric signal dataset and the fracture energy dataset, and to estimate fracture energy values corresponding to electric signal values of a target battery cell using the fracture energy estimation model.

## Description

### CROSS-REFERENCE TO RELATED APPLICATION

The present application claims the benefit of the priority of Korean Patent Application No. 10-2024-0003046, filed on January 8, 2024, which is hereby incorporated by reference in its entirety.

### TECHNICAL FIELD

Embodiments disclosed in this document relate to a battery diagnosis device, a battery diagnosis method, and a battery diagnosis system.

### BACKGROUND ART

Recently, research and development on secondary batteries have been actively conducted. Here, secondary batteries are batteries that can be charged and discharged, and may be interpreted including both conventional Ni/Cd batteries, Ni/MH batteries, and recent lithium ion batteries. Among secondary batteries, lithium ion batteries may have much higher energy density than conventional Ni/Cd batteries, Ni/MH batteries, etc. and may be manufactured to be small and lightweight, and thus lithium ion batteries may have high usability as a power source for mobile devices. Recently, the scope of use of the lithium ion batteries has expanded to include a power source for electric vehicles, and the lithium ion batteries are attracting attention as a next-generation energy storage medium.

In a manufacturing process of a battery cell, a welding process of attaching an electrode tab to a battery can through welding may be performed. Destructive inspection may be performed to check the quality of the welding process, but non-destructive inspection of welding quality may be required to solve problems such as yield loss. Conventionally, a method of estimating a welding defect based on whether electric signal data used in the welding process exceeds a normal range has been used, but the conventional method may have a problem in that it has low defect detection accuracy.

### DISCLOSURE OF THE INVENTION

### TECHNICAL PROBLEM

One objective of embodiments disclosed in this document is to provide a battery diagnosis device, a battery diagnosis method, and a battery diagnosis system capable of improving the accuracy of non-destructive inspection for estimating a welding defect of a battery cell electrode tab.

The technical objectives of the embodiments disclosed in this document are not limited to the technical problems mentioned above, and other technical problems not mentioned can be clearly understood by those skilled in the art from the descriptions below.

### TECHNICAL SOLUTION

According to some embodiments, a battery diagnosis device includes a data management unit configured to collect an electric signal dataset of a welding process of forming an electrode tab on a plurality of sample battery cells and a fracture energy dataset of a fracture experiment for measuring a tensile strength while separating the electrode tab from the plurality of sample battery cells and a control unit configured to generate a fracture energy estimation model for estimating fracture energy values corresponding to electric signal values based on the electric signal dataset and the fracture energy dataset, and to estimate fracture energy values corresponding to electric signal values of a target battery cell using the fracture energy estimation model.

According to some embodiments, the fracture energy estimation model includes an artificial intelligence model trained through machine learning, and the artificial intelligence model includes at least one of a random forest regression model, an artificial neural network (ANN) model, and a multiple regression model.

According to some embodiments, the electrical signal values include welding voltage, transformer voltage, minimum welding voltage, initial welding voltage, end welding voltage, welding current variation, initial welding current, maximum welding current, average welding current, welding heat input, initial welding resistance, welding resistance difference, and end welding resistance.

According to some embodiments, the electrical signal values have signal weights based on a degree to which the electrical signal values affect the quality of the electrode tab, and the fracture energy estimation model is configured to be trained based on the signal weights.

According to some embodiments, the fracture energy dataset includes a graph of tensile strength according to displacement of the electrode tab in each sample battery cell and fracture energy of the electrode tab of each sample battery cell is calculated based on a value obtained by integrating the tensile strength up to displacement at which the electrode tab is separated.

According to some embodiments, the control unit is configured to diagnose whether welding of the electrode tab of the target battery cell is defective by comparing the fracture energy value of the target battery cell with a threshold energy value.

According to some embodiments, the control unit is configured to calculate a correlation index between actual fracture energy values and estimated fracture energy values of the plurality of sample battery cells, and adjust the threshold energy value based on the correlation index.

According to some embodiments, a battery diagnosis method includes collecting an electric signal dataset of a welding process of forming an electrode tab on a plurality of sample battery cells, collecting a fracture energy dataset of a fracture experiment for measuring a tensile strength while separating the electrode tab from the plurality of sample battery cells, generating a fracture energy estimation model for estimating fracture energy values corresponding to electric signal values based on the electric signal dataset and the fracture energy dataset, and estimating fracture energy values corresponding to electric signal values of a target battery cell using the fracture energy estimation model.

According to some embodiments, the fracture energy estimation model includes an artificial intelligence model trained through machine learning, and the artificial intelligence model includes at least one of a random forest regression model, an artificial neural network (ANN) model, and a multiple regression model.

According to some embodiments, the electrical signal values include welding voltage, transformer voltage, minimum welding voltage, initial welding voltage, end welding voltage, welding current variation, initial welding current, maximum welding current, average welding current, welding heat input, initial welding resistance, welding resistance difference, and end welding resistance.

According to some embodiments, the electrical signal values have signal weights based on a degree to which the electrical signal values affect the quality of the electrode tab, and the fracture energy estimation model is configured to be trained based on the signal weights.

According to some embodiments, the fracture energy dataset includes a graph of tensile strength according to displacement of the electrode tab in each sample battery cell and fracture energy of the electrode tab of each sample battery cell is calculated based on a value obtained by integrating the tensile strength up to displacement at which the electrode tab is separated.

According to some embodiments, the battery diagnosis method further includes diagnosing whether welding of the electrode tab of the target battery cell is defective by comparing the fracture energy value of the target battery cell with a threshold energy value.

According to some embodiments, the diagnosing of whether welding of the electrode tab of the target battery cell is defective includes calculating a correlation index between actual fracture energy values and estimated fracture energy values of the plurality of sample battery cells, and adjusting the threshold energy value based on the correlation index.

According to some embodiments, a battery diagnosis system includes a welding device configured to perform a welding process of forming electrode tabs on a plurality of sample battery cells, a measuring device configured to perform a fracture experiment for measuring tensile strength while separating the electrode tabs from the plurality of sample battery cells, and a control unit configured to generate a fracture energy estimation model for estimating fracture energy values corresponding to electric signal values based on the electric signal dataset and the fracture energy dataset of the welding process, and to estimate fracture energy values corresponding to electric signal values of a target battery cell using the fracture energy estimation model.

### ADVANTAGEOUS EFFECTS

According to the embodiments disclosed in this document, a battery diagnosis device, a battery diagnosis method, and a battery diagnosis system capable of improving the accuracy of non-destructive inspection for estimating a welding defect of a battery cell electrode tab can be provided.

Technical effects according to the embodiments disclosed in this document are not limited to the effects mentioned above, and other effects not mentioned will be clearly understood by those skilled in the art according to the disclosure of this document.

### BRIEF DESCRIPTION OF THE DRAWINGS

FIG. 1 illustrates an environment in which a battery diagnosis system operates according to some embodiments.
FIG. 2 illustrates elements constituting a battery diagnosis system according to some embodiments.
FIG. 3 illustrates elements constituting a battery diagnosis device according to some embodiments.
FIG. 4 illustrates a graph representing an electric signal data set according to some embodiments.
FIG. 5 illustrates a process of generating a fracture energy estimation model according to some embodiments.
FIG. 6 illustrates graphs representing a correlation between actual fracture energy values and estimated fracture energy values according to some embodiments.
FIG. 7 illustrates a process of performing a fracture experiment on battery cells through a measuring device according to some embodiments.
FIG. 8 illustrates a process of calculating fracture energy based on a graph of tensile strength according to displacement of an electrode tab according to some embodiments.
FIG. 9 illustrates steps of a battery diagnosis method according to some embodiments.

### MODE FOR CARRYING OUT THE INVENTION

Hereinafter, embodiments described in this document are described with reference to the accompanying drawings. However, this is not intended to limit the disclosure of this document to a specific embodiment, but should be understood to include various modifications, equivalents, and/or alternatives of the embodiments described in this document.

Embodiments of this document and the terms used therein are not intended to limit the technical features described in this document to a specific embodiment, but should be understood to include various modifications, equivalents, or alternatives of the embodiment. In connection with the description of the drawings, similar reference numerals may be used for similar or related components. The singular form of a noun corresponding to an item may include one or more of said items, unless the context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase, or all possible combinations thereof. Terms such as "first", "second", "firstly", "secondly", "A", "B", "(a)", or "(b)" may be used merely to distinguish one component from another, and do not limit the components in any other respect (e.g., importance or order) unless specifically stated otherwise.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner or wirelessly), or indirectly (through a third component).

The method according to various embodiments disclosed in this document may be provided by being included in a computer program product. The computer program product may be traded between a seller and a buyer as a product. The computer program product may be distributed in the form of a machine-readable storage medium (e.g., compact disc read only memory (CD-ROM)), or may be distributed online (e.g., downloaded or uploaded) through an application store or directly between two user devices. In the case of online distribution, at least a part of the computer program product may be temporarily stored or temporarily generated in a machine-readable storage medium such as a memory of a manufacturer's server, an application store's server, a relay server.

According to the embodiments disclosed in this document, each of the components (e.g., modules or programs) described above may include a single or plurality of entities, and some of the plurality of entities may be separated and placed in other components. According to the embodiments disclosed in this document, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to the embodiments disclosed in this document, the operations performed by a module, program, or other component may be performed sequentially, in parallel, repeatedly, or heuristically, or one or more of the operations may be performed in a different order, omitted, or performed by being added with one or more other operations.

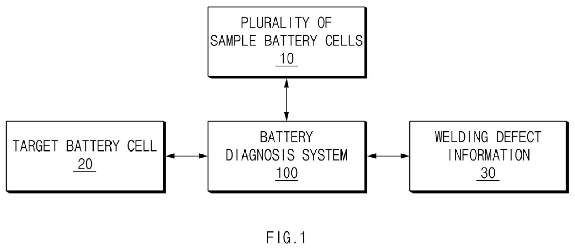

FIG. 1 illustrates an environment in which a battery diagnosis system operates according to some embodiments.

Referring to FIG. 1, a battery diagnosis system 100 may generate a fracture energy estimation model using a plurality of sample battery cells 10, and may generate welding defect information 30 of a target battery cell 20 using the fracture energy estimation model.

The battery diagnosis system 100 may include a system for diagnosing welding quality of a welding process of forming an electrode tab on a battery cell. When the welding quality is excessively low, the strength with which the electrode tab is attached to the battery cell may be low, which may cause problems with the durability of the battery cell. The battery diagnosis system 100 may estimate the welding quality of the electrode tab of the battery cell in a non-destructive manner, and for this purpose, electrical signal data of the welding process be utilized.

A dataset utilized for generating a fracture energy estimation model based on the plurality of sample battery cells 10 may be extracted. The fracture energy estimation model may be trained based on electrical signal data of the welding process of the plurality of sample battery cells 10. When training of the fracture energy estimation model is completed, the fracture energy estimation model may be used to estimate whether the welding quality of the target battery cell 20 is defective. A dataset for the plurality of sample battery cells 10 may be updated periodically, and the fracture energy estimation model may also be retrained periodically.

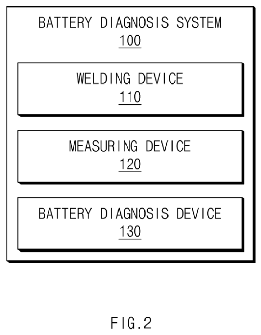

FIG. 2 illustrates elements that constitute a battery diagnosis system according to some embodiments.

Referring to FIG. 2, the battery diagnosis system 100 may include a welding device 110, a measuring device 120, and a battery diagnosis device 130. However, the present invention is not limited thereto, and some components may be omitted from the battery diagnosis system 100, or other general-purpose components may be further included in the battery diagnosis system 100.

The welding device 110 may perform a welding process for forming the electrode tab on the plurality of sample battery cells 10 and the target battery cell 20. The welding device 110 may operate based on electrical signal data such as a current signal value, a voltage signal value, and a welding resistance value. The quality of the electrode tab formed on the battery cell may be determined based on electrical signal values.

The measuring device 120 may perform a fracture experiment to physically separate the electrode tab from the plurality of sample battery cells 10 and the target battery cell 20. During the fracture experiment, a tensile strength of the electrode tab may be measured. When the tensile strength according to displacement δ at which the electrode tab is separated from a battery can of the battery cell is analyzed, fracture energy of the battery cell may be measured. It can be interpreted that the greater the fracture energy, the higher the welding quality of the electrode tab.

The battery diagnosis device 130 may acquire an electric signal data set of the welding process of the plurality of sample battery cells 10 from the welding device 110, and may acquire a fracture energy data set of the fracture experiment for the plurality of sample battery cells 10 from the measuring device 120. The battery diagnosis device 130 may generate the fracture energy estimation model based on the plurality of sample battery cells 10, and may use the model to estimate the welding defect information 30 of the target battery cell 20.

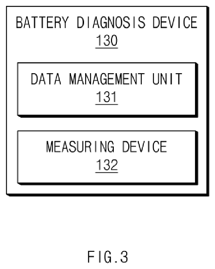

FIG. 3 illustrates elements constituting a battery diagnosis device according to some embodiments.

Referring to FIG. 3, the battery diagnosis device 130 may include a data management unit 131 and a control unit 132. However, the present invention is not limited thereto, and some components may be omitted from the battery diagnosis device 130, or other general-purpose components may be further included in the battery diagnosis device 130.

The data management unit 131 may manage the electric signal data set provided from the welding device 110 and the fracture energy data set provided from the measuring device 120. For example, the data management unit 131 may include a memory device and/or a storage device, and may manage the electric signal data set and the fracture energy data set using a database.

The control unit 132 may perform various process operations of the battery diagnosis device 130. The control unit 132 may execute instructions, software, applications, programs, etc. stored in a memory, a storage, a cache, etc., and may perform computational processing on data. For example, the control unit 132 may be implemented in the form of at least one of a microprocessor, a CPU, a GPU, and an AP.

The data management unit 131 may be configured to collect the electric signal data set of the welding process of forming the electrode tab on the plurality of sample battery cells 10. The electric signal data set may be provided from the welding device 110. The electric signal data set may include a current signal, a voltage signal, a welding resistance value, etc., and may determine the welding quality of the electrode tab.

The data management unit 131 may be configured to collect the fracture energy data set of the fracture experiment for measuring the tensile strength while separating the electrode tab from the plurality of sample battery cells 10. The fracture energy data set may be provided from the measuring device 120. The fracture energy dataset may include data obtained by measuring displacement at which the electrode tab is separated from the battery can and the tensile strength corresponding to the displacement. The fracture energy dataset may represent fracture energy of the electrode tab, and the fracture energy may represent the welding quality.

The control unit 132 may be configured to generate a fracture energy estimation model that estimates fracture energy values corresponding to electrical signal values based on the electrical signal dataset and the fracture energy dataset. A matching relationship between the electrical signal data and the fracture energy data may function as training data. When a large number of such matching relationships are learned, the fracture energy estimation model may predict fracture energy data for newly input electrical signal data. The fracture energy estimation model may include an artificial intelligence model trained through various machine learning techniques.

The control unit 132 may be configured to estimate the fracture energy values corresponding to the electric signal values of the target battery cell 20 using the fracture energy estimation model. When the fracture energy value is too low, the quality of the electrode tab welding of the target battery cell 20 may fall short of a reference value. The welding defect information 30 indicating whether the electrode tab welding is defective may be derived based on the fracture energy value. In this manner, non-destructive welding quality inspection of the target battery cell 20 may be performed.

According to the embodiment, the fracture energy estimation model may include an artificial intelligence model trained through machine learning, and the artificial intelligence model may include at least one of a random forest regression model, an artificial neural network (ANN) model, and a multiple regression model. The RF regression model, ANN model, multiple regression model, and other appropriate AI models may be utilized as models for learning the matching relationship between the electric signal data and the fracture energy data. The AI model may be continuously updated as the diagnosis of the battery diagnosis device 130 is accumulated.

According to the embodiment, the electric signal values may include welding voltage, transformer voltage, minimum welding voltage, initial welding voltage, end welding voltage, welding current variation, initial welding current, maximum welding current, average welding current, welding heat input, initial welding resistance, welding resistance difference, and end welding resistance. In the conventional technique for determining a welding defect, it is analyzed whether each of the electric signal values is out of the normal range is analyzed. However, in order to improve the lack of accuracy of the conventional technique, the battery diagnosis system 100 may determine the welding defect using the fracture energy estimation model based on the electric signal values.

According to the embodiment, the electric signal values may have signal weights based on a degree to which the electric signal values affect the electrode tab quality, and the fracture energy estimation model may be configured to be trained based on the signal weights. For example, weights of current-related values among the electrical signal values may be higher than weights of the other values, and this difference in weights may be reflected in a training process of the fracture energy estimation model. For example, the weights of the initial welding current may be higher than the weights of the other values.

According to the embodiment, the fracture energy dataset may include a graph of the tensile strength according to displacement δ of the electrode tab in each sample battery cell, and the fracture energy of the electrode tab of each sample battery cell may be calculated based on a value obtained by integrating the tensile strength up to the displacement at which the electrode tab separates. When the value of the tensile strength is integrated from an attachment position of electrode tab (δᵢ = 0) to a detachment position of the electrode tab (δ = δ_{f}), the fracture energy of the electrode tab may be calculated, which may represent an attachment strength and welding quality of the electrode tab.

According to the embodiment, the control unit 132 may be configured to diagnose whether welding of the electrode tab of the target battery cell 20 is defective by comparing the fracture energy value of the target battery cell 20 with a threshold energy value. The threshold energy value for determining the welding defect of the electrode tab may be preset, and the defect information 30 of the target battery cell 20 may be generated through the comparison with the threshold energy value. The target battery cell 20 determined to be normal may be transported for subsequent packaging work, etc., and the target battery cell 20 determined to be defective may be transported for re-inspection or disposal, etc.

According to the embodiment, the control unit 132 may be configured to calculate a correlation index between actual fracture energy values and estimated fracture energy values of the plurality of sample battery cells 10, and adjust the threshold energy value based on the correlation index. For example, the correlation index may include an R² determination coefficient. As the correlation index increases, the threshold energy value may be closer to a measured threshold value based on the actual fracture energy values, and as the correlation index decreases, the threshold energy value may be lower than the measured threshold value.

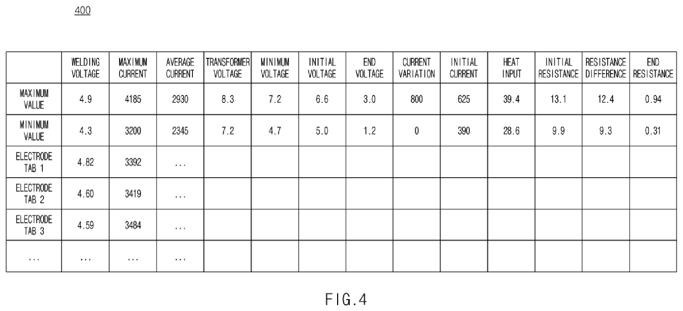

FIG. 4 illustrates a graph representing an electric signal data set according to some embodiments.

Referring to FIG. 4, a graph 400 representing an electric signal data set may be illustrated. The graph 400 may represent electric signal values for a plurality of electrode tabs.

The electric signal values may include welding voltage, transformer voltage, minimum welding voltage, initial welding voltage, end welding voltage, welding current variation, initial welding current, maximum welding current, average welding current, welding heat input, initial welding resistance, welding resistance difference, and end welding resistance. The graph 400 may represent the maximum value and minimum value of a normal range of each electric signal value.

In the conventional method, welding quality is determined based on whether there is an electric signal value exceeding the normal range of the graph 400, but the battery diagnosis system 100 may form a fracture energy estimation model using the electric signal values of the graph 400 and determine welding quality using the fracture energy estimation model.

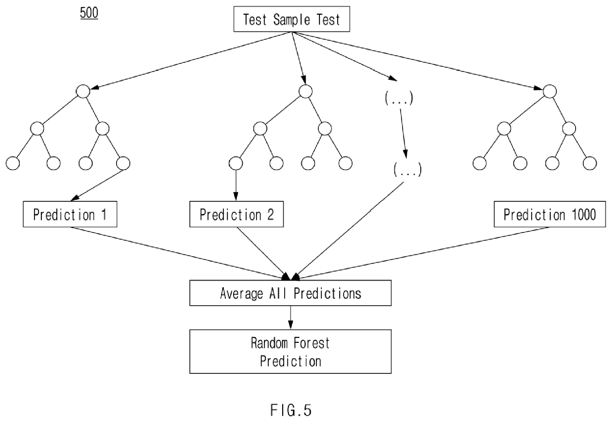

FIG. 5 illustrates a process of generating a fracture energy estimation model according to some embodiments.

Referring to FIG. 5, an RF model 500 representing a process of generating the fracture energy estimation model may be illustrated. The RF model 500 may be a type of the artificial intelligence model trained through machine learning.

The RF model 500 may calculate evaluation values for welding quality according to the range of electric signal values (for example, Prediction 1 to Prediction 1000), and may derive a final evaluation value by calculating a weighted average using probability values of the evaluation values.

For example, the RF model 500 may classify thirteen electric signal values into binary, calculate 2¹³ evaluation values, and derive a final evaluation value as a weighted average of the 2¹³ evaluation values. Meanwhile, when some values (for example, current-related values) of the electric signal values have higher weights than other values, the final evaluation value may be derived by reflecting the weights.

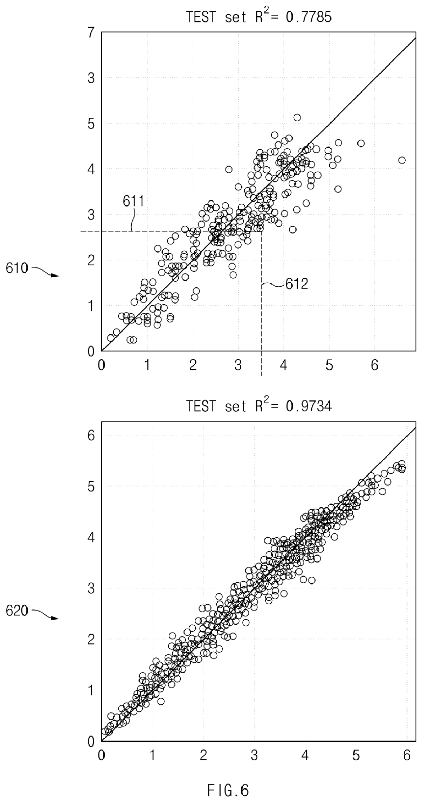

FIG. 6 illustrates graphs illustrating a correlation between actual fracture energy values and estimated fracture energy values according to some embodiments.

Referring to FIG. 6, graphs 610 and 620 illustrating a correlation between the actual fracture energy values and the estimated fracture energy values may be illustrated.

The graph 610 may illustrate a prediction result for electrical signal data not utilized in the training process of the fracture energy estimation model and R² determination coefficient of the graph 610 may be 0.7785. The graph 620 may illustrate a prediction result for electrical signal data utilized in the training process of the fracture energy estimation model, and R² determination coefficient of the graph 620 may be 0.9734.

The graph 610 may illustrate a measured threshold value 612 based on actual fracture energy values and a threshold energy value 611 used for diagnosing the welding defect of the target battery cell 20. The measured threshold value 612 based on the fracture inspection may be set based on the actual fracture energy values for the plurality of sample battery cells 10.

On the other hand, the threshold energy value 611 may be set based on the estimated fracture energy values by the fracture energy estimation model, rather than the actual fracture energy values. Therefore, the threshold energy value 611 may be set more conservatively (smaller) than the measured threshold value 612, and the lower the R² determination coefficient, the larger the difference between the threshold energy value 611 and the measured threshold value 612.

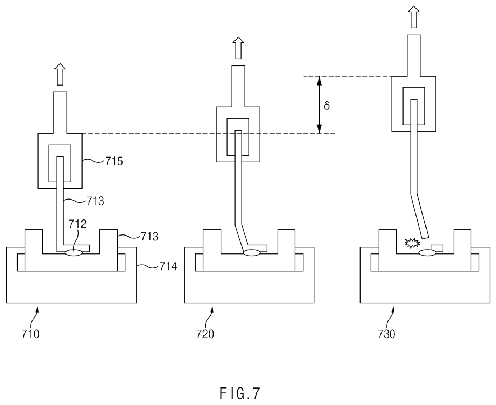

FIG. 7 illustrates a process of performing a fracture experiment on battery cells using a measuring device according to some embodiments.

Referring to FIG. 7, processes 710, 720, and 730 for performing the fracture experiment on battery cells through the measuring device 120 may be illustrated.

In the first process 710, a battery can 711 and an electrode tab 713 can be joined through a weld part 712, and a lower fixing jig 714 and an upper fixing jig 715 of the measuring device 120 may fix the battery can 711 and the electrode tab 713.

While proceeding from the first process 710 to the third process 730, the upper fixing jig 715 may separate the electrode tab 713 from the battery can 711. During the separation process, the displacement δ at which the electrode tab 713 is separated and the tensile strength formed in the electrode tab 713 and/or the weld part 712 may be measured according to the displacement δ.

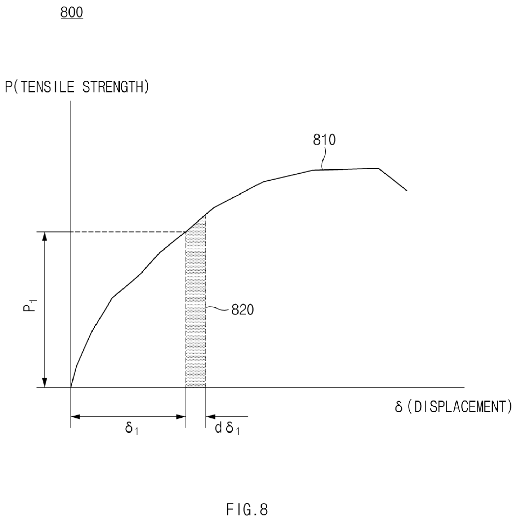

FIG. 8 illustrates a process of calculating fracture energy based on a graph of tensile strength according to displacement of an electrode tab according to some embodiments.

Referring to FIG. 8, a process of calculating fracture energy based on a graph 800 of tensile strength according to the displacement of the electrode tab may be described.

In the graph 800, a curve 810 representing tensile strength according to displacement of an electrode tab, a minute integral value 820, and separation displacement 830 may be represented. In the curve 810, it may be confirmed that the tensile strength is also 0 when the displacement δ is 0. The tensile strength may increase as the displacement δ increases. At the separation displacement 830, the electrode tab 713 may be separated from the battery can 711.

When adding all the minute integral values 820 from 0 to the separation displacement 830, the measured fracture energy of the electrode tab may be measured. The measured fracture energy may refer to the energy required to separate the electrode tab, which may refer to the strength and quality of the electrode tab weld. In the same manner as the graph 800, a fracture energy dataset for the plurality of sample battery cells 10 may be generated.

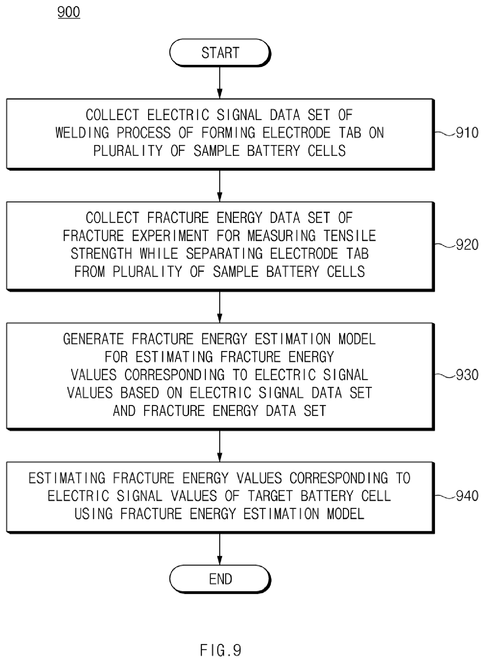

FIG. 9 illustrates steps constituting a battery diagnosis method according to some embodiments.

Referring to FIG. 9, a battery diagnosis method 900 may include steps 910 to 940. However, the present invention is not limited thereto, and some steps may be omitted or other general steps may be added, and the steps of the battery diagnosis method 900 may be executed in a different order from the illustrated order.

The battery diagnosis method 900 may be composed of steps that are processed in time series in the battery diagnosis device 130. Therefore, even if contents are omitted below, the contents described above for the battery diagnosis device 130 may be equally applied to the battery diagnosis method 900.

Steps 910 to 940 of the battery diagnosis method 900 may be performed by the data management unit 131 and the control unit 132 of the battery diagnosis device 130.

In step 910, the battery diagnosis device 130 may perform collecting an electric signal data set of a welding process of forming an electrode tab on a plurality of sample battery cells.

In step 920, the battery diagnosis device 130 may perform collecting a fracture energy data set of a fracture experiment for measuring a tensile strength while separating an electrode tab from the plurality of sample battery cells.

In step 930, the battery diagnosis device 130 may perform generating a fracture energy estimation model for estimating fracture energy values corresponding to electric signal values based on the electric signal data set and the fracture energy data set.

In step 940, the battery diagnosis device 130 may perform estimating fracture energy values corresponding to electric signal values of a target battery cell using the fracture energy estimation model.

According to the embodiment, the battery diagnosis method 900 may be implemented in the form of a computer program stored in a computer-readable storage medium. That is, the computer program may include instructions for implementing the battery diagnosis method 900, and the instructions of the program may be stored in the computer-readable storage medium. The computer program may include a mobile application.

According to the embodiment, the computer-readable storage medium may include magnetic media such as hard disks, floppy disks, and magnetic tapes, optical media such as CD-ROMs, DVDs, magneto-optical media such as floptical disks, and hardware devices specifically configured to store and execute computer program instructions such as ROMs, RAMs, flash memory, etc. The computer program instructions may include machine language codes produced by a compiler and high-level language codes executable by a computer using an interpreter, etc.

The terms "include," "configure," or "have" described above, unless specifically stated to the contrary, mean that the corresponding component may be included, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an illustrative description of the technical idea disclosed in this document, and a person skilled in the art to which the embodiments disclosed in this document belong may make various modifications and variations thereto without departing from the essential characteristics of the embodiments disclosed in this document. Therefore, the embodiments disclosed in this document are not intended to limit the technical idea of the embodiments disclosed in this document, but rather to explain it, and the scope of the technical idea disclosed in this document is not limited by these embodiments. The scope of protection of the technical idea disclosed in this document should be interpreted by the claims below, and all technical ideas within the equivalent scope should be interpreted as being included in the scope of the rights of this document.

### [Description of symbols]

10: plurality of sample battery cells 20: target battery cell
30: welding defect information 100: battery diagnosis system
110: welding device 120: measuring device
130: battery diagnosis device 131: data management unit
132: control unit

## Claims

1. A battery diagnosis device comprising:
a data management unit configured to collect an electric signal dataset of a welding process of forming an electrode tab on a plurality of sample battery cells and a fracture energy dataset of a fracture experiment for measuring a tensile strength while separating the electrode tab from the plurality of sample battery cells; and
a control unit configured to generate a fracture energy estimation model for estimating fracture energy values corresponding to electric signal values based on the electric signal dataset and the fracture energy dataset, and to estimate fracture energy values corresponding to electric signal values of a target battery cell using the fracture energy estimation model.

2. The battery diagnosis device of claim 1, wherein the fracture energy estimation model includes an artificial intelligence model trained through machine learning, and
the artificial intelligence model includes at least one of a random forest regression model, an artificial neural network (ANN) model, and a multiple regression model.

3. The battery diagnosis device of claim 1, wherein the electrical signal values include welding voltage, transformer voltage, minimum welding voltage, initial welding voltage, end welding voltage, welding current variation, initial welding current, maximum welding current, average welding current, welding heat input, initial welding resistance, welding resistance difference, and end welding resistance.

4. The battery diagnosis device of claim 3, wherein the electrical signal values have signal weights based on a degree to which the electrical signal values affect the quality of the electrode tab, and
the fracture energy estimation model is configured to be trained based on the signal weights.

5. The battery diagnosis device of claim 1, wherein the fracture energy dataset includes a graph of tensile strength according to displacement of the electrode tab in each sample battery cell and
fracture energy of the electrode tab of each sample battery cell is calculated based on a value obtained by integrating the tensile strength up to displacement at which the electrode tab is separated.

6. The battery diagnosis device of claim 1, wherein the control unit is configured to diagnose whether welding of the electrode tab of the target battery cell is defective by comparing the fracture energy value of the target battery cell with a threshold energy value.

7. The battery diagnosis device of claim 6, wherein the control unit is configured to calculate a correlation index between actual fracture energy values and estimated fracture energy values of the plurality of sample battery cells, and adjust the threshold energy value based on the correlation index.

8. A battery diagnosis method comprising:
collecting an electric signal dataset of a welding process of forming an electrode tab on a plurality of sample battery cells;
collecting a fracture energy dataset of a fracture experiment for measuring a tensile strength while separating the electrode tab from the plurality of sample battery cells;
generating a fracture energy estimation model for estimating fracture energy values corresponding to electric signal values based on the electric signal dataset and the fracture energy dataset; and
estimating fracture energy values corresponding to electric signal values of a target battery cell using the fracture energy estimation model.

9. The battery diagnosis method of claim 8, wherein the fracture energy estimation model includes an artificial intelligence model trained through machine learning, and
the artificial intelligence model includes at least one of a random forest regression model, an artificial neural network (ANN) model, and a multiple regression model.

10. The battery diagnosis method of claim 8, wherein the electrical signal values include welding voltage, transformer voltage, minimum welding voltage, initial welding voltage, end welding voltage, welding current variation, initial welding current, maximum welding current, average welding current, welding heat input, initial welding resistance, welding resistance difference, and end welding resistance.

11. The battery diagnosis method of claim 10, wherein the electrical signal values have signal weights based on a degree to which the electrical signal values affect the quality of the electrode tab, and
the fracture energy estimation model is configured to be trained based on the signal weights.

12. The battery diagnosis method of claim 8, wherein the fracture energy dataset includes a graph of tensile strength according to displacement of the electrode tab in each sample battery cell and
fracture energy of the electrode tab of each sample battery cell is calculated based on a value obtained by integrating the tensile strength up to displacement at which the electrode tab is separated.

13. The battery diagnosis method of claim 8, wherein the battery diagnosis method further includes diagnosing whether welding of the electrode tab of the target battery cell is defective by comparing the fracture energy value of the target battery cell with a threshold energy value.

14. The battery diagnosis method of claim 13, wherein the diagnosing of whether welding of the electrode tab of the target battery cell is defective includes:
calculating a correlation index between actual fracture energy values and estimated fracture energy values of the plurality of sample battery cells; and
adjusting the threshold energy value based on the correlation index.

15. A battery diagnosis system comprising:
a welding device configured to perform a welding process of forming electrode tabs on a plurality of sample battery cells;
a measuring device configured to perform a fracture experiment for measuring tensile strength while separating the electrode tabs from the plurality of sample battery cells; and
a control unit configured to generate a fracture energy estimation model for estimating fracture energy values corresponding to electric signal values based on the electric signal dataset and the fracture energy dataset of the welding process, and to estimate fracture energy values corresponding to electric signal values of a target battery cell using the fracture energy estimation model.
